# EUROPÄISCHE PATENTSCHRIFT

(11) **EP 2 944 706 B1**
(45) Veröffentlichungstag und Bekanntmachung des Hinweises auf die Patenterteilung: **11.09.2019**
(21) Anmeldenummer: 14167917.5
(22) Anmeldetag: 12.05.2014
(51) Int. Cl.: C23C 14/16, C23C 14/30, C23C 14/58, C21D 1/673

(54) **Verfahren zur Herstellung eines durch Warmumformen geformten Stahlbauteils aus einem eine metallische Beschichtung aufweisendem Stahlblech**
Method for manufacturing a steel component by means of thermoforming from a steel sheet having a metallic coating
Procédé de fabrication d'un composant en acier moulé par déformation à chaud à partir d'une tôle d'acier présentant un revêtement métallique

(43) Veröffentlichungstag der Anmeldung: 18.11.2015
(73) Patentinhaber: ThyssenKrupp Steel Europe AG, 47166 Duisburg (DE); thyssenkrupp AG, 45143 Essen (DE)
(72) Erfinder: Schuhmacher, Bernd, 44227 Dortmund (DE); Schwerdt, Christian, 47058 Duisburg (DE); Schrooten, Axel, 44137 Dortmund (DE); Bause, Ralf, 44143 Dortmund (DE)
(74) Vertreter: Cohausz & Florack

(56) Entgegenhaltungen:
- EP-A1- 2 312 005
- EP-A1- 2 578 719
- JP-A- 2010 018 860
- JP-A- 2011 137 210
- S. PALDEY ET AL: "Cathodic arc deposited FeAl coatings: properties and oxidation characteristics", MATERIALS SCIENCE AND ENGINEERING A, Bd. 355, Nr. 1-2, 25. August 2003 (2003-08-25), Seiten 208-215, XP055147246, ISSN: 0921-5093, DOI: 10.1016/S0921-5093(03)00076-5

## Beschreibung

Die Erfindung betrifft ein Verfahren zur Herstellung eines dreidimensional geformten Stahlbauteils aus einem eine metallische Beschichtung aufweisendem Stahlblech, das aufgeheizt und anschließend durch Warmumformen in das Stahlbauteil umgeformt wird, wobei das verwendete Stahlblech eine Fe-Al-basierte Legierung als metallische Beschichtung aufweist.

Beim Erhitzen von Stahl auf Temperaturen oberhalb von ca. 500°C in einer Sauerstoff enthaltenden Atmosphäre bildet sich auf der Stahloberfläche eine Oxidschicht, sogenannter Zunder. Die Zunderbildung ist in der Regel unerwünscht, da sie erhebliche Probleme bereitet. So kann das Einpressen des Zunders beim Umformen des Stahlblechs zu Oberflächenmarkierungen bzw. zu einer unbefriedigenden oder gar inakzeptablen Oberflächenqualität führen. Der Zunder erhöht wegen seiner hohen Härte den Verschleiß der das umzuformende Stahlblech tragenden Transportrollen sowie der Umformwerkzeuge. Das Entfernen des Zunders verursacht zusätzliche Kosten.

Die JP 2011137210 A beschreibt ein Verfahren zur Herstellung von warmumformbarem, mit Aluminium beschichteten Stahlblech durch Schmelztauchbeschichtung, wobei die Al-Beschichtung des schmelztauchbeschichteten Stahlblechs durch Wärmebehandlung in einem Haubenglühofen bei einer Temperatur im Bereich von 600 und 800°C in eine Al-Fe-Legierungsschicht umgewandelt wird.

Die EP 2 312 005 A1 offenbart ein aluminiumbeschichtetes Stahlblech zum Warmumformen, dessen Al-Beschichtung ebenfalls durch Wärmebehandlung in einem Haubenglühofen in eine Al-Fe-Legierungsschicht umgewandelt wird. Die Glühtemperatur soll dabei im Bereich von 600 und 750°C liegen.

Die JP 2010 018860 A offenbart ebenfalls ein aluminiumbeschichtetes Stahlblech zum Warmumformen, dessen Al-Beschichtung durch Wärmebehandlung in einem Haubenglühofen in eine Al-Fe-Legierungsschicht umgewandelt wird.

Die EP 2 578 719 A1 beschreibt einen Stahl, der durch Schmelztauchbeschichten mit einer Al-Legierungsschicht versehenen ist, wobei die Beschichtung 25-75 Gew.-% Fe, 2-20 Gew.-% Mg, 0,02-2 Gew.-% Ca, Rest Aluminium und unvermeidbare Verunreinigungen aufweist.

In der Veröffentlichung "Cathodic arc deposited FeAl coatings: properties and oxidation characteristics", von S. Paldey et al. in Materials Science and Engineering A, Bd. 355, Nr. 1-2, 25. August 2003, Seiten 208-215, werden Fe-Al-Beschichtungen auf Stahl beschrieben, die mittels physikalischer Gasphasenabscheidung (PVD) hergestellt werden und einen Al-Anteil von 40-45 Gew.-% aufweisen.

Der vorliegenden Erfindung liegt die Aufgabe zugrunde, ein Verfahren der eingangs genannten Art anzugeben, bei dem die Probleme der Verzunderung weitgehend vermieden werden. Insbesondere liegt der Erfindung die Aufgabe zugrunde, ein Stahlblech zur Verfügung zu stellen, das mit einer gegen Zunder schützenden metallischen Beschichtung speziell für durch Warmumformen herzustellende Bauteile versehen ist.

Hinsichtlich des Verfahrens wird diese Aufgabe durch ein Verfahren mit den im Anspruch 1 angegebenen Merkmalen gelöst. Vorteilhafte und bevorzugte Ausgestaltungen des erfindungsgemäßen Verfahrens sind in den auf Anspruch 1 rückbezogenen Ansprüchen angegeben.

Um das Stahlblech bzw. ein daraus durch Warmumformen (Presshärten) hergestelltes Stahlbauteil vor Verzunderung zu schützen, wird erfindungsgemäß eine Fe-Al-basierte Legierung mittels physikalischer Gasphasenabscheidung, wobei eine Temperierung des Stahlblechs auf eine Temperatur im Bereich von 250 bis 500°C nach der Anwendung der physikalischen Gasphasenabscheidung durchgeführt wird, so dass die Beschichtung bereits vor dem für das Warmumformen durchzuführenden Aufheizen des beschichteten Stahlblechs eine bis über 900°C stabile Fe-Al-Phase aufweist, und wobei die so erzeugte Beschichtung
30 - 60 Gew.-% Fe,
   mindestens ein Element der aus Mg, Ti, Si, Li und Ca bestehenden Gruppe von Legierungselementen mit einem Anteil von
0,1 - 10 Gew.-% Mg,
0,1 - 5 Gew.-% Ti,
0,1 - 10 Gew.-% Si,
0,1 - 10 Gew.-% Li und
0,1 - 10 Gew.-% Ca,
   und zudem als Rest mindestens 28 Gew.-% Al enthält,
   wobei die Beschichtung maximal 20 Gew.-% der aus Mg, Ti, Si, Li und Ca bestehenden Legierungselemente enthält.

Im Unterschied zu einer Beschichtung mit einer intermetallischen Legierungsschicht, die durch eine "Vorglühung" erzeugt wird, wird erfindungsgemäß die Fe-basierte bzw. Fe-Al-basierte Legierung direkt appliziert. Dazu eignet sich besonders eine physikalische Gasphasenabscheidung (sogenannte PVD-Verfahren). Dieses Verfahren ermöglicht einen kontinuierlichen Beschichtungsprozess.

Die erfindungsgemäße Beschichtung hat folgende Vorteile:
1. Die Reaktion der Beschichtung mit den Ofenbauteilen der Warmumformanlage, insbesondere den keramischen Transportrollen, ist durch die bereits stabilisierte Fe-Al-Phase unterbunden. Das hat positive Auswirkungen auf die Oberflächenqualität des beschichteten Stahlblechs und verringert den Wartungsaufwand bezüglich des Ofens.
2. Die bereits vorlegierte Beschichtung lässt sich aufgrund besserer Emissivität (Absorptionsfähigkeit) deutlich schneller erwärmen, was eine Verkürzung des Warmumformprozesses ermöglicht. Dies führt zu einer Erhöhung der Produktivität und einer Reduzierung der Herstellungskosten der erzeugten pressgehärteten Stahlbauteile.
3. Der Verschleiß des Umformwerkzeuges ist durch die Vermeidung von Anbackungen in Folge von noch nicht durchlegierten ("teigigen") Beschichtungsbestandteilen herabgesetzt. Auch dadurch werden Stillstandzeiten minimiert und Kosten gespart.

Die Legierungsbestandteile Magnesium, Titan, Silizium, Lithium und Calcium haben ein höheres Korrosionspotenzial als Eisen, wodurch ein gewisser kathodischer Schutz in eventuell beschädigten Bereichen der pressgehärteten Beschichtung begünstigt wird. Aufgrund der Tendenz zur Bildung einer niedrigschmelzenden Phase mit Aluminium und der damit verbundenen Gefahr von flüssigphaseninduzierten Rissen wird bei der erfindungsgemäßen Beschichtung auf die Verwendung von Zink als Legierungselement verzichtet.

Eine bevorzugte Ausgestaltung der Erfindung ist dadurch gekennzeichnet, dass die Fe-Al-basierte Legierung mindestens 38 Gew.-% Al enthält. Hierdurch wird die Schutzwirkung gegen Verzunderung erhöht, ohne den Grundwerkstoff negativ zu beeinflussen.

Nach einer weiteren vorteilhaften Ausgestaltung der Erfindung enthält die Fe-Al-basierte Legierung 0,1 - 10 Gew.-% Mg und/oder 0,1 - 5 Gew.-% Ti. Die Legierungsbestandteile Magnesium und Titan haben einen positiven Effekt auf die Oberfläche der Beschichtung. Versuche haben gezeigt, dass sich in einem weiten Prozessfenster eine optimale Rauheit einstellt, die zum einen zu einem verbesserten Korrosionsschutz durch eine reduzierte Grundrauheit (Ra, Rz) führt, und zum anderen eine erhöhte Spitzenzahl (RPc) ergib, durch welche die Lackhaftung der im KTL-Prozess aufgetragenen Lackschicht verbessert wird.

Vorteilhaft ist auch, wenn die Fe-Al-basierte Legierung nach einer weiteren bevorzugten Ausgestaltung 0,1 - 10 Gew.-% Li und/oder 0,1 - 10 Gew.-% Ca enthält. Versuche haben gezeigt, dass hierdurch der kathodische Korrosionsschutz deutlich verbessert werden kann. Dies gilt insbesondere auch für die Zugabe von Magnesium.

Besonders gute Ergebnisse hinsichtlich der Schutzwirkung gegen Verzunderung sowie Korrosion lassen sich erzielen, wenn die Fe-Al-basierte Legierung nach einer weiteren bevorzugten Ausgestaltung maximal 15 Gew.-% und bevorzugt maximal 12 Gew.-% der aus Mg, Ti, Si, Li und Ca bestehenden Legierungselemente enthält.

Die nachträgliche Temperierung des beschichteten Stahlsubstrats auf 250 - 500°C bewirk eine Verbesserung der Schichthaftung. Wird im Anschluss schmelztauchbeschichtet, erübrigt sich eine zusätzliche Erwärmung.

Zur Erzeugung von gewichtsreduzierten Stahlbauteilen mit sehr hohen mechanischen Eigenschaften kann das Stahlblech in weiterer Ausgestaltung des erfindungsgemäßen Verfahren während des Warmumformens und/oder im Anschluss an das Warmumformen durch rasches Abkühlen gehärtet werden.

Nachfolgend wird die Erfindung anhand von Ausführungsbeispielen (Versuchen) näher erläutert.

### Versuch 1:

Ein Grundwerkstoff, zum Beispiel ein presshärtbarer Stahl vom Typ 22MnB5, wurde mittels physikalischer Gasphasenabscheidung (PVD) im kontinuierlichen Beschichtungsprozess mit ca. 60 Gew.-% Al und ca. 39 Gew.-% Fe sowie ca. 1 Gew.-% Ti beschichtet. Erreicht wurde dies durch das simultane Abscheiden von Eisen und Titan mittels eines Elektronenstrahlverdampfers sowie das Abscheiden von Aluminium in einem separaten thermischen PVD-Prozessschritt. Es ergab sich eine Schichtdicke von ca. 8 µm. Diese Schicht wurde anschließend in einem Durchlaufofen thermisch bei ca. 500°C und einer Behandlungszeit (Haltezeit) von ca. 60 Sekunden nachverdichtet. Die thermische Nachverdichtung dient der Haftverbesserung der Schichten sowie einer ersten Legierungsbildung durch Feststoffdiffusion.

Das so im kontinuierlichen Bandbeschichtungsprozess erzeugte Stahlband wurde anschließend, in Anlehnung an die Weiterverarbeitungsprozesse beim Kunden, zu Platinen geschnitten und dem Presshärteprozess zugeführt. Während der von 6 Minuten auf 3 Minuten verkürzten Aufheizphase im Labor-Presshärteofen stellte sich ein metallischer Überzug (Beschichtung) mit ca. 55 Gew.-% Fe und ca. 45 Gew.-% Al sowie eine nur ca. 150 nm dicke Aluminium- und Titanoxidschicht ein. Der Überzug wies eine für die Weiterverarbeitung, insbesondere Lackierung gut geeignete Grundrauheit von Ra = 0,8 - 1 µm und RPC = 150 - 200 auf.

Es wurde festgestellt, dass weder an den keramischen Transportrollen des Durchlaufofens noch an den Umformwerkzeugen Aluminiumanhaftungen nachzuweisen waren.

Es wurde überraschenderweise auch festgestellt, dass die im Unterschied zu einem Referenzblech mit einem Aluminium-Silizium-Überzug reduzierte Grundrauheit zu einer Verbesserung des Korrosionsschutzes an im KTL-Verfahren beschichteten Stahlbauteilen führt.

### Versuch 2:

Ein Grundwerkstoff, z.B. presshärtbarer Stahl vom Typ 22MnB5, wurde mittels physikalischer Gasphasenabscheidung im kontinuierlichen Beschichtungsprozess mit ca. 50 Gew.-% Al und ca. 45 Gew.-% Fe sowie ca. 5 Gew.-% Mg beschichtet. Erreicht wurde dies durch das simultane Abscheiden von Aluminium und Magnesium mittels Jet-PVD aus getrennten Tiegeln sowie das Abscheiden von Eisen in einem separaten Beschichtungsschritt mittels Elektronenstrahlverdampfung. Die so erhaltene Schichtdicke betrug ca. 8 µm. Diese Schicht wurde anschließend in einem Durchlaufofen thermisch bei ca. 400°C ca. 60 Sekunden lang nachverdichtet. Die thermische Nachverdichtung dient der Haftverbesserung der Schichten sowie einer ersten Legierungsbildung durch Feststoffdiffusion.

Das so im kontinuierlichen Bandbeschichtungsprozess erzeugte Stahlband wurde anschließend, in Anlehnung an die Weiterverarbeitungsprozesse beim Kunden, zu Platinen geschnitten und dem Presshärteprozess zugeführt. Während der von 6 Minuten auf 3,5 Minuten verkürzten Aufheizphase im Labor-Presshärteofen stellte sich ein metallischer Überzug (Beschichtung) mit ca. 55 Gew.-% Fe, ca. 42 Gew.-% Al und ca. 3 Gew.-% Magnesium sowie eine ca. 1 µm dicke Aluminium- und Magnesiumoxidschicht ein. Der Überzug wies eine für die Weiterverarbeitung, insbesondere Lackierung gut geeignete Grundrauheit von Ra = 1 - 2,2 µm und RPC = 100 - 120 auf.

Es wurde festgestellt, dass weder an den keramischen Transportrollen des Durchlaufofens noch an den Umformwerkzeugen Aluminiumanhaftungen nachzuweisen waren.

Ferner wurde überraschenderweise auch festgestellt, dass die Korrosionstiefe in das Stahlblech, festgestellt durch automobiltypische Untersuchungen an einem Ritz und der Blechkante, an im KTL-Verfahren beschichteten Bauteilen aufgrund des vorhandenen Magnesiums deutlich geringer ausfällt als bei Stahlfeinblech mit einer Aluminium-Silizium-Standardbeschichtung.

### Versuch 3 (nicht erfindungsgemäße Variante):

Auf einen Grundwerkstoff, z.B. presshärtbarer Stahl vom Typ 22MnB5, wurde zuerst eine ca. 4 µm dicke Fe-Schicht elektrolytisch aufgebracht. Anschließend, nach der Erwärmung des Substrats auf 350°C, wurde mittels eines thermischen PVD-Prozesses eine ca. 6 µm dicke Aluminium-Magnesium-Schicht appliziert. Beide Legierungsbestandteile (Al und Mg) wurden aus zwei getrennten Tiegeln gleichzeitig abgeschieden. Die resultierende Al-Schicht hatte einen Mg-Anteil von ca. 10 Gew.-%. Diese Schicht bewirkt auf dem Stahlsubstrat verbleibend auch einen in der Regel passiven Korrosionsschutz am pressgehärteten Bauteil.

Das so im kontinuierlichen Bandbeschichtungsprozess erzeugte Stahlband wurde anschließend, in Anlehnung an die Weiterverarbeitungsprozesse beim Kunden, zu Platinen geschnitten und dem Presshärteprozess zugeführt. Während der von 6 Minuten auf 3,5 Minuten verkürzten Aufheizphase im Labor-Presshärteofen stellte sich ein metallischer Überzug (Beschichtung) mit ca. 60 Gew.-% Fe, ca. 42 Gew.-% Al und ca. 3 Gew.-% Magnesium sowie eine ca. 1 µm dicke Aluminium- und Magnesiumoxidschicht ein. Der Überzug wies eine für die Weiterverarbeitung, insbesondere Lackierung gut geeignete Grundrauheit von Ra = 1 - 2,2 µm und RPC = 100 - 120 auf. Es wurde festgestellt, dass weder an den keramischen Transportrollen des Durchlaufofens noch an den Umformwerkzeugen Aluminiumanhaftungen nachzuweisen waren.

Zudem wurde überraschenderweise festgestellt, dass die Korrosionstiefe in das Stahlsubstrat, festgestellt durch automobiltypische Untersuchungen am Ritz und der Blechkante, an im KTL-Verfahren beschichteten Bauteilen aufgrund des vorhandenen Magnesiums deutlich geringer ausfällt als bei Stahlfeinblech mit einer Aluminium-Silizium-Standardbeschichtung.

## Patentansprüche

1. Verfahren zur Herstellung eines dreidimensional geformten Stahlbauteils aus einem eine metallische Beschichtung aufweisendem Stahlblech, das aufgeheizt und anschließend durch Warmumformen in das Stahlbauteil umgeformt wird, wobei das verwendete Stahlblech eine Fe-Al-basierte Legierung als metallische Beschichtung aufweist, **dadurch gekennzeichnet, dass** die Fe-Al-basierte Legierung mittels physikalischer Gasphasenabscheidung direkt auf das Stahlblech appliziert wird, wobei eine Temperierung des Stahlblechs auf eine Temperatur im Bereich von 250 bis 500°C nach der Anwendung der physikalischen Gasphasenabscheidung durchgeführt wird, so dass die Beschichtung bereits vor dem für das Warmumformen durchzuführenden Aufheizen des beschichteten Stahlblechs eine bis über 900°C stabile Fe-Al-Phase aufweist, und wobei die so erzeugte Beschichtung
30 - 60 Gew.-% Fe,
mindestens ein Element der aus Mg, Ti, Si, Li und Ca bestehenden Gruppe von Legierungselementen mit einem Anteil von
0,1 - 10 Gew.-% Mg,
0,1 - 5 Gew.-% Ti,
0,1 - 10 Gew.-% Si,
0,1 - 10 Gew.-% Li und
0,1 - 10 Gew.-% Ca,
und zudem als Rest mindestens 28 Gew.-% Al enthält,
wobei die Beschichtung maximal 20 Gew.-% der aus Mg, Ti, Si, Li und Ca bestehenden Legierungselemente enthält.

2. Verfahren nach Anspruch 1, **dadurch gekennzeichnet, dass** die Fe-Al-basierte Legierung mindestens 38 Gew.-% Al enthält.

3. Verfahren nach Anspruch 1 oder 2, **dadurch gekennzeichnet, dass** die Fe-Al-basierte Legierung 0,1 - 10 Gew.-% Mg und/oder 0,1 - 5 Gew.-% Ti enthält.

4. Verfahren nach einem der Ansprüche 1 bis 3, **dadurch gekennzeichnet, dass** die Fe-Al-basierte Legierung 0,1 - 10 Gew.-% Li und/oder 0,1 - 10 Gew.-% Ca enthält.

5. Verfahren nach einem der Ansprüche 1 bis 4, **dadurch gekennzeichnet, dass** das Stahlblech während des Warmumformens und/oder im Anschluss an das Warmumformen durch rasches Abkühlen gehärtet wird.

## Claims

1. A process for producing a three-dimensionally shaped steel component from a steel sheet having a metallic coating, which is heated and then converted by hot forming in the steel component, wherein the steel sheet used comprises a Fe-Al-based alloy as a metallic coating, **characterized in that** the Fe-Al-based alloy is applied directly to the steel sheet by means of physical vapor deposition, wherein a tempering of the steel sheet to a temperature in the range of 250 to 500° C is performed after the application of the physical vapor deposition, so that the coating before the heating of the coated steel sheet to be carried out for hot forming has already an Fe-Al phase that is stable to above 900° C, and wherein the coating thus produced includes
30 - 60% by weight Fe,
at least one element of the group of alloying elements consisting of Mg, Ti, Si, Li and Ca in a proportion of
0.1 -10% by weight Mg,
0.1 - 5% by weight of Ti,
0.1 - 10% by weight of Si,
0.1 - 10% by weight of Li and
0.1 - 10% by weight of Ca,
and additionally includes at least 28% by weight of Al as the remainder,
wherein the coating includes at most 20% by weight of alloying elements consisting of Mg, Ti, Si, Li, and Ca.

2. The process according to claim 1, **characterized in that** the Fe-Al based alloy includes at least 38% by weight Al.

3. The process according to claim 1 or 2, **characterized in that** the Fe-Al based alloy includes 0.1 -10% by weight Mg and/or 0.1 - 5% by weight Ti.

4. The process according to any of claims 1 to 3, **characterized in that** the Fe-Al based alloy includes 0.1 - 10% by weight Li and/or 0.1 - 10% by weight Ca.

5. The process according to any of claims 1 to 4, **characterized in that** the steel sheet is hardened by rapid cooling during hot forming and/or after hot forming.

## Revendications

1. Procédé de fabrication d'un composant en acier de forme tridimensionnelle, réalisé à partir d'une tôle d'acier, qui, présentant un revêtement métallique, est chauffée et transformée ensuite en ce composant en acier par formage à chaud, sachant que la tôle d'acier est dotée d'un alliage à base de Fe-Al en tant que revêtement métallique,
**caractérisé en ce que** l'alliage à base de Fe-Al est appliqué directement sur la tôle d'acier selon le procédé de physique de dépôt en phase gazeuse, sachant que la tôle d'acier est tempérée à une température située dans le domaine de 250 à 500 °C après l'application du dépôt en phase gazeuse physique de sorte que le revêtement présente déjà une phase Fe-Al stable jusqu'à plus de 900 °C avant le chauffage de la tôle d'acier revêtue qui doit être effectué pour le formage à chaud, et sachant que le revêtement ainsi réalisé contient
30 - 60 % en poids de Fe,
au moins un élément appartenant au groupe d'éléments d'alliages consistant en Mg, Ti, Si, Li et Ca, avec une part de
0,1 - 10 % en poids de Mg
0,1 - 5 % en poids de Ti
0,1 - 10 % en poids de Si
0,1 - 10 % en poids de Li et
0,1 - 10 % en poids de Ca,
et, de plus, au moins 28 % en poids d'Al en tant que résidu,
sachant que le revêtement contient au maximum 20 % en poids d'éléments d'alliages qui consistent en Mg, Ti, Si, Li et Ca.

2. Procédé selon la revendication 1,
**caractérisé en ce que** l'alliage à base de Fe-Al, contient au moins 38 % en poids d'Al.

3. Procédé selon revendication 1 ou 2,
**caractérisé en ce que** l'alliage à base de Fe-Al, contient 0,1 - 10 % en poids de Mg et/ou 0,1 - 5 % en poids de Ti.

4. Procédé selon l'une des revendications 1 à 3,
**caractérisé en ce que** l'alliage à base de Fe-Al, contient 0,1 - 10 % en poids de Li et/ou 0,1 - 10 % en poids de Ca.

5. Procédé selon l'une des revendications 1 à 4,
**caractérisé en ce que** la tôle d'acier est durcie par refroidissement rapide pendant le formage à chaud et/ou à la suite du formage à chaud.
